# EUROPEAN PATENT SPECIFICATION

(11) **EP 2 188 411 B1**
(45) Date of publication and mention of the grant of the patent: **26.10.2011**
(21) Application number: 08807390.3
(22) Date of filing: 21.08.2008
(51) Int. Cl.: C23C 14/34, H01J 37/34

(54) **SPUTTERING SYSTEM**
SPUTTERSYSTEM
SYSTÈME DE PULVÉRISATION CATHODIQUE

(30) Priority: 30.08.2007 EP 07115308
(43) Date of publication of application: 26.05.2010
(73) Proprietor: Koninklijke Philips Electronics N.V., 5621 BA Eindhoven (NL); Philips Intellectual Property & Standards GmbH, 20099 Hamburg (DE)
(72) Inventor: HENNINGER, Georg, NL-5656 AE Eindhoven (NL); HUNSCHE, Berno, NL-5656 AE Eindhoven (NL); SELL, Konrad, NL-5656 AE Eindhoven (NL); RUSKE, Manfred, NL-5656 AE Eindhoven (NL); DIEDERICH, Thomas, NL-5656 AE Eindhoven (NL)
(74) Representative: Bekkers, Joost J.J
(86) International application number: PCT/IB2008/053354
(87) International publication number: WO 2009/027905

(56) References cited:
- EP-A- 0 275 965
- WO-A-95/00677
- US-A- 5 466 991
- US-B1- 6 635 124
- LIMPAECHER R ET AL: "MAGNETIC MULTIPOLE CONTAINMENT OF LARGE UNIFORM COLLISIONLESS QUIESCENT PLASMAS" REVIEW OF SCIENTIFIC INSTRUMENTS, AIP, MELVILLE, NY, US, vol. 44, no. 6, 1 June 1973 (1973-06-01), pages 726-731, XP000560655 ISSN: 0034-6748

## Description

### FIELD OF THE INVENTION

The invention relates to a device for sputtering at least one selected material onto a substrate and bringing about a reaction of this material, comprising a vacuum chamber, in which a substrate holder is arranged, at least one magnetron sputtering mechanism, which is arranged in a workstation close to the substrate holder and which has a target of the selected material which is suitable for producing a first plasma for sputtering at least one material onto the substrate, as well as a secondary plasma mechanism for producing a secondary plasma, which is arranged in the workstation close to the magnetron sputtering mechanism and close to the substrate holder, the sputtering mechanism and the secondary plasma mechanism forming a sputtering zone and an activation zone. The invention also relates to a method for coating a substrate, in which firstly material is deposited on a substrate by means of a sputtering process and the deposited material then reacts in plasma, which contains the necessary reactive species, to form a compound.

### BACKGROUND OF THE INVENTION

The use of reactive magnetron sputtering is known for applying thin films of metal compounds. A reactive sputtering is carried out in this connection such that the substrate is fastened over the metallic target and a compounding of the applied metal film takes place at the same time and at the same location as the depositing of the metal atoms. To achieve stoichiometric films with acceptable depositing rates, careful balancing of the conditions is necessary, so the film is completely composed or compounded on the substrate, but the sputtering target surface is not "poisoned" by excessive reaction, as a state such as this leads to lower sputtering rates and often to arc formation on the target surface.

Furthermore, it is known to guide the substrate, on which the metal compound is to be deposited, alternatingly over the sputtering target and through a reactive atmosphere. In this manner, the depositing of the metal atoms is in each case partially separated, with respect to time and space, from the compounding of the film. It is furthermore known that the depositing of an oxide layer can be improved in that oxygen in the compounding zone is activated by a plasma, as excited oxygen species react more easily with the metal layer.

The drawback in the aforementioned prior art is the necessity for physical and atmospheric separation of the reaction and deposition zone. This separation, for example, limits the number of targets and reaction zones which can be arranged in a specific vacuum chamber, so the total quantity of film application is limited.

To avoid this drawback, it is proposed in EP 0 516 436 B1 and WO 95006677 to bring the sputtering and activation zone together atmospherically and physically, in that all the separation sheets are removed or no differential pumping is used and the plasmas of these two zones are thus effectively mixed to form a single continuous plasma which is used both for sputtering material from the target and for the reaction thereof on the substrate. A magnetron sputtering device is disclosed, in which a sputtering mechanism and a secondary plasma mechanism are arranged, which in each case form sputtering and activation zones, which are atmospherically and physically adjacent, and are suitable for improving the plasma of the sputtering mechanism to bring about a reaction of the ions of the reactive gas with the sputtering material with a comparatively low ambient part pressure of the reactive gas. In this case, a substrate holder is provided, which guides the substrates past the associated selected workstations.

It was possible to significantly improve the coating process by means of sputtering and subsequent bringing about of a reaction, for example an oxidation, by means of the device disclosed in EP 0 516 436 B1 and WO 95006677. The process time is substantially limited by the reaction to be brought about, for example the oxidation of the deposited material.

### SUMMARY OF THE INVENTION

It is an object of the present invention to improve the previously known device in such a way that the reaction rate in the activation zone is increased so that the process times can be reduced. According to the invention, this object is achieved in that at least two electromagnets and/or radially magnetized toric magnets as well as at least one magnetic multipole, which is formed from a plurality of permanent magnets, are arranged to produce magnetic fields to include the secondary plasma.

A device is provided by the invention, in which the reaction rate in the activation zone is increased, so the process times can be reduced.

In a development of the invention, the substrate holder is a drum and at least one electromagnet and/or a radially magnetized toric magnet is arranged inside the drum. As a result, the plasma density close to or on the substrate is increased. The thus increased concentration of reactive species such as ions and radicals leads to an increase in the reaction rate.

In a configuration of the invention, all the magnets arranged to produce the magnetic field are arranged outside the vacuum chamber. This facilitates the mechanical arrangement. Furthermore, the outlay for cooling the magnetic components is reduced.

In an alternative configuration of the invention, all the magnets arranged to produce the magnetic field are arranged inside the vacuum chamber. This reduces the installation size of the device.

At least one electromagnet is preferably connected to an alternating voltage source to produce a magnetic alternating field. Advantageously, at least one of the electromagnets producing a magnetic alternating field is arranged in front of the substrate holder. As a result, the ion flow inside the plasma is further concentrated on the substrate.

In a configuration of the invention, at least one electromagnet is connected to a direct voltage source to produce a constant magnetic field. As a result, a further modification of the magnetic field produced to include the secondary plasma is made possible.

At least one electromagnet is preferably operated in such a way that a superimposed constant and alternating field is produced, so that a change in the magnetic field strength is implemented without a polarity reversal of the magnetic field. As a result, an effective compression of the plasma and a release of the ions necessary for the reaction on the substrate is brought about.

In a further configuration of the invention, the secondary plasma mechanism is a microwave generator. Generators of this type have been successful in producing the required plasma.

The microwave generator is preferably set up to produce a pulsed microwave. As a result, with the same output, higher plasma densities are achieved than in continuous microwave operation.

The arranged magnets advantageously generate magnetic fields with a maximum magnetic flux density, which is above the necessary magnetic flux density depending on the microwave frequency that is necessary to produce electron cyclotron resonance (ECR) in microwave plasma. This resonance state brings about an improved plasma excitation and a significant increase in the plasma density and the electron temperature. The magnetic flux density B_{ECR} necessary for the resonance case is calculated according to: B_{ECR} = f_{µW} mₑ/e₀, wherein f_{µW} is the microwave frequency, mₑ is the mass of an electron and e₀ is the elementary charge. A magnetic flux density of 875 Gauss is produced from this for a typical microwave frequency of 2.45 GHz, so that ECR conditions are present.

In a further configuration of the invention, a potential is applied at the substrate holder, which is different from the potential of the vacuum chamber. As a result, a further acceleration of the plasma ions is brought about in the direction of the substrate.

The invention is further based on an object of providing a method for coating a substrate, in which the reaction rate of the reaction to be brought about of the metal deposited on the substrate, for example an oxidation, is increased. According to the invention, this object is achieved in that the density and the degree of ionization of the plasma is increased with the aid of magnetic fields, which are produced by at least two electromagnets and/or radially magnetized toric magnets as well as at least one magnetic multipole, which is formed from a plurality of permanent magnets.

A method for coating a substrate is provided by the invention, in which the reaction rate of the reaction to be brought about of the deposited metal on the substrate is increased.

Other developments and configurations of the invention are given in the remaining sub-claims. One embodiment of the invention is shown in the drawings and will be described in detail below.

### BRIEF DESCRIPTION OF THE DRAWINGS

In the drawings:
Fig. 1 shows the schematic simplified view of the cross-section of a drum-like vacuum coating device;

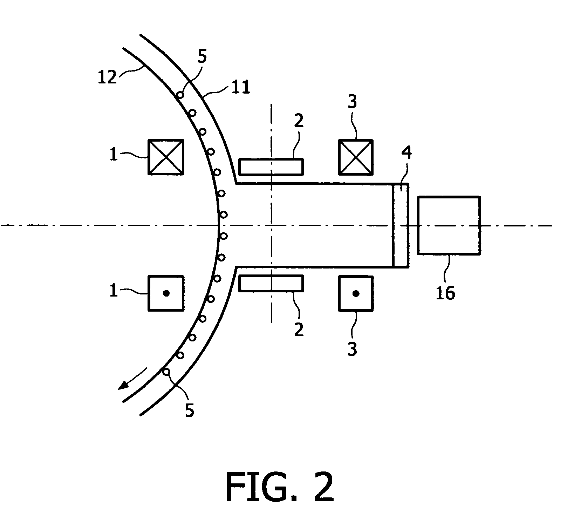

Fig. 2 shows a detail of the magnetron sputtering device in the region of the activation zone;
Fig. 3 shows the section 1-1 through the multipole magnets in Fig. 2;

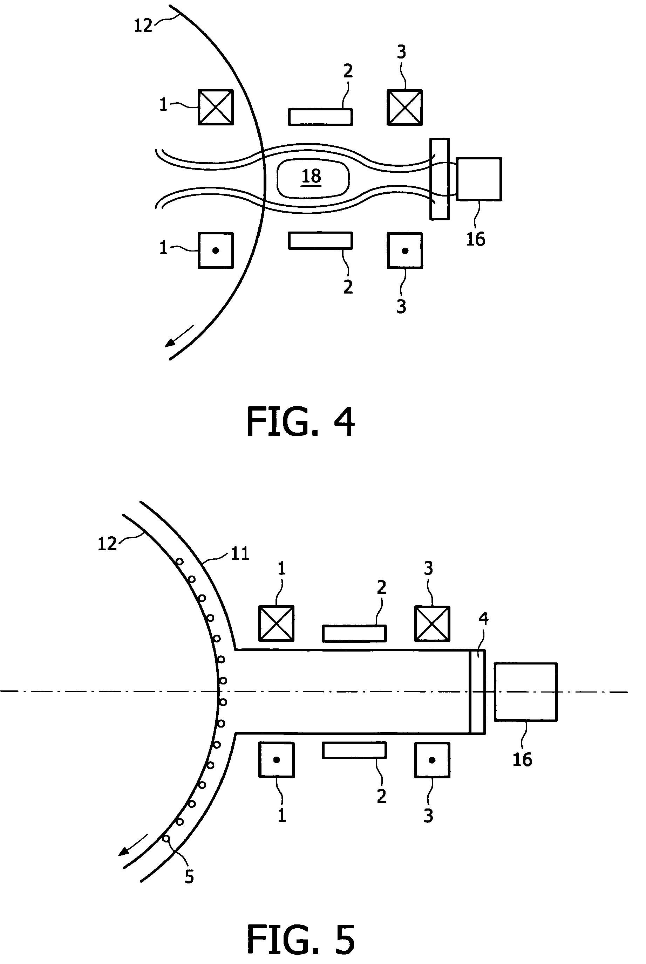

Fig. 4 shows the schematic view of the magnetic field lines and the plasma inclusion in the arrangement according to Fig. 2 and
Fig. 5 shows the plan view of a detail of a magnetron sputtering device in a further embodiment in the region of the activation zone.

### DETAILED DESCRIPTION OF EMBODIMENTS

The sputtering device selected as an embodiment is a development of the sputtering system as described in EP 0 516 436 B1, reference being made here to the disclosure of this document.

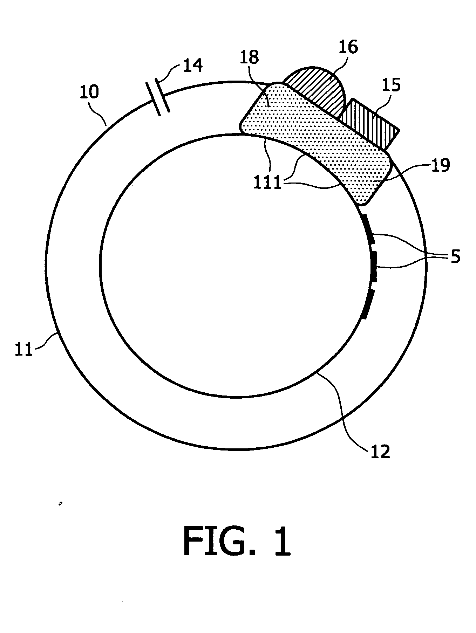

With reference to Fig. 1, a sputtering system 10 has a housing 11, the periphery of which forms a vacuum chamber. The housing 11 may itself be connected to a vacuum system, not shown. A magnetron sputtering device 15 is arranged on the periphery of the vacuum housing of the housing 11, which is also designated hereinafter as the chamber 11, closely adjacent to the plasma production device 16. In the embodiment, the plasma production device 16 is a microwave generator.

During operation, an inert sputtering gas, such as, for example, argon, is introduced into the chamber 11 through an inlet 14. In addition, a reaction gas, such as, for example, oxygen, is introduced through the inlet 14. As the substrates, which are arranged on the drum 12, are rotated into the region 19 of the larger plasma 111, a metal film sputtered from the target 15 is deposited. The reaction of this film with the reaction gas begins directly when the film is deposited in the region 19 below the target 15. If the substrate 5 is guided into the region 18 of the plasma under the microwave generator 16, this reaction is continued and the conversion of the film into a dielectric with the desired stoichiometry is brought to an end. In order to achieve a dielectric film of a desired thickness, this sequence can be repeated by rotating the drum 12. By means of the arrangement of further sputtering target plasma production devices, multi-layer films of various materials can be applied to the substrates 5.

To increase the reaction rate - in the case of oxygen as the reaction gas, the oxidation rate - arranged in the activation zone in the region 18 is a magnetic field arrangement, consisting of two electromagnets 1, 3 and a magnetic multipole 2, which is constructed from a plurality of permanent magnets. The magnetic fields are used to include the electrons. The microwave generator 16 operates at 2.45 gigahertz and the magnetic fields initiated by the magnetic field arrangement have a maximum magnetic flux density of more than 875 Gauss, so a resonance state (ECR state) is brought about. A reciprocal action of the magnetic field with the ions of the plasma can be ignored as the ions in the ECR plasma have a thermal behaviour.

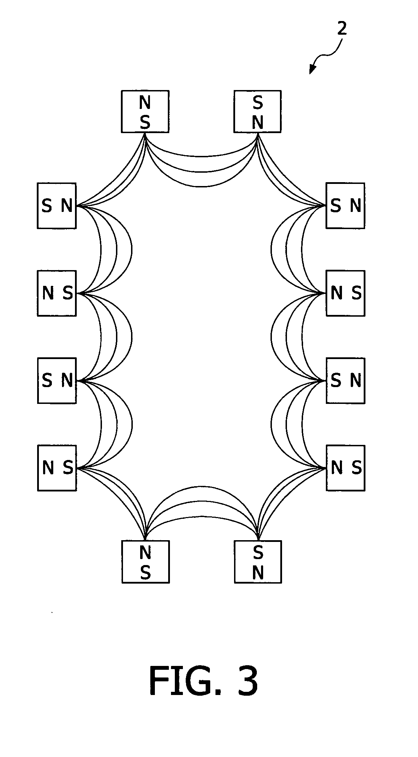

In the magnetic field arrangement according to Fig. 3, an electromagnet is arranged inside the drum 12. The multipole magnet 2 and a second electromagnet 3 are arranged with respect to the electromagnet 1 outside the vacuum chamber on the housing 11. The substrates 5 fastened to the drum 12 are moved on the rotating drum 12 by the magnetic field configuration. With the aid of the two electromagnets, a magnetic double mirror is constructed, which is used for the axial inclusion of the electrons. Instead of magnetic coils, radially magnetized toric magnets can also be used here. Owing to the curvature of the magnetic mirror field, a drift of the electrons radially outwardly takes place. This drift movement leads to plasma instabilities. For stabilization, a radial magnetic inclusion of the electrons is implemented with the aid of the multipole magnet 2, which is arranged between the two electromagnets 1, 3.

The presence of ECR conditions leads to an increase in the absorption of microwave energy in the plasma by means of the resonant excitation of the electrons when passing through the ECR surfaces. As a result of the resonant electron excitation, increased ionization processes occur and therefore an increase in the charge carrier density (plasma excitation). The ions are included by the plasma potential distribution forming (electrostatic inclusion). The cause of the plasma potential distribution is large gradients in the electron density and electron temperature. These gradients are produced from the ECR conditions occurring locally to a limited extent (location of the maximum electron excitation by the microwaves).

To protect the microwave window 4 arranged on the housing, this microwave window 4 should be positioned in such a way that no ECR conditions are present on the vacuum side directly in front of the microwave window 4. An excessive thermal stressing of the microwave window 4 is thus prevented. The ECR surface of the electromagnet 3 remote from the drum should preferably be arranged on the atmosphere side. Furthermore, the microwave window 4 is protected by keeping away the plasma via the magnetic plasma inclusion.

In order to bring about a targeted ion flow onto the substrates, applied at the drum 12, on which the substrates 5 are fastened, is a potential, which is different from that of the vacuum chamber 11. For this purpose, a negative bias is applied at the drum 12. To prevent an ion flow onto the substrates 5, a positive bias should be applied here if a reaction with neutral particles is preferred.

By means of the above-described magnetic field arrangement, a plasma inclusion is brought about, which leads to an increase in the charge carrier density and the electron temperature. The substrates 5, which are located on the drum 12, are guided by rotation of the drum 12 through the included plasma and therefore subjected to improved oxidation. In addition, the loss of charge carriers, in other words recombination and migration of the ions and electrons in regions of the receivers, in which they do not contribute to the maintenance of a plasma, and no effective oxidization of the substrates 5 can occur, is minimized.

## Claims

1. A device (10) for sputtering at least one selected material onto a substrate (5) and bringing about a reaction of this material, the device comprising a vacuum chamber (11), in which a substrate holder (12) is arranged, at least one magnetron sputtering mechanism (15), which is arranged in a workstation close to the substrate holder (12) and which has a target of the selected material which is suitable for producing a first plasma for sputtering at least one material onto the substrate (5), as well as a secondary plasma mechanism (16) for producing a secondary plasma, which is arranged in the workstation close to the magnetron sputtering mechanism (15) and close to the substrate holder (12), the magnetron sputtering mechanism (15) and the secondary plasma mechanism (16) forming a sputtering zone and an activation zone, **characterized in that** at least two electromagnets (1, 3) and/or radially magnetized toric magnets as well as at least one magnetic multipole (2), which is formed from a plurality of permanent magnets, are arranged to produce magnetic fields to include the secondary plasma.

2. A device as claimed in claim 1, **characterized in that** the substrate holder (12) is a drum and **in that** at least one electromagnet (1) and/or one radially magnetized toric magnet is arranged inside the drum (12).

3. A device as claimed in claim 1, **characterized in that** all the magnets (1, 2, 3) arranged to produce the magnetic fields are arranged outside the vacuum chamber (11).

4. A device as claimed in claim 1 or 2 **characterized in that** all the magnets (1, 2, 3) arranged to produce the magnetic fields are arranged inside the vacuum chamber.

5. A device as claimed in any one of the preceding claims, **characterized in that** at least one electromagnet for producing a magnetic alternating field is connected to an alternating voltage source.

6. A device as claimed in any one of the preceding claims, **characterized in that** at least one electromagnet for producing a constant magnetic field is connected to a direct voltage source.

7. A device as claimed in any one of the preceding claims, **characterized in that** at least one electromagnet is operated in such a way that a superimposed constant and alternating field is produced.

8. A device as claimed in any one of the preceding claims, **characterized in that** the secondary plasma mechanism (16) is a microwave generator.

9. A device as claimed in claim 8, **characterized in that** the microwave generator (16) is set up to produce a pulsed microwave.

10. A device as claimed in claims 8 and 9, **characterized in that** the maximum magnetic flux density of the magnetic fields produced by the arranged magnets (1, 2, 3) corresponds at least to the necessary magnetic flux density matched to the microwave frequency used to produce electron cyclotron resonance (ECR).

11. A device as claimed in any one of the preceding claims, **characterized in that** a potential is applied at the substrate holder (12), which is different from the potential of the vacuum chamber (11).

12. A device as claimed in any one of the preceding claims, **characterized in that** the secondary plasma brings about a reaction to convert the selected material into an oxide, nitride, carbide, hydride, sulfide, oxynitride or mixtures thereof.

13. A device as claimed in any one of the preceding claims, **characterized in that** the secondary plasma is an oxygen-rich plasma and **in that** the reaction brought about is an oxidation.

14. A method for coating a substrate, in which firstly material is deposited on a substrate by means of a sputtering process and the deposited material then reacts in a plasma, which contains the necessary reactive species, to form a compound, **characterized in that** the plasma density and the degree of ionization of the plasma are increased with the aid of magnetic fields, which are produced by the device as claimed in any one of the preceding claims.

15. A method as claimed in claim 14, **characterized in that** the maximum magnetic flux density of the magnetic fields produced by the arranged magnets (1, 2, 3) corresponds at least to the necessary magnetic flux density matched to the microwave frequency used, to produce electron cyclotron resonance (ECR).

## Patentansprüche

1. Einrichtung (10), um mindestens ein ausgewähltes Material auf ein Substrat (5) aufzusputtern und eine Reaktion dieses Materials zu bewirken, wobei die Einrichtung eine Vakuumkammer (11), in der ein Substrathalter (12) angeordnet ist, mindestens einen Magnetron-Sputtermechanismus (15), der in einer Arbeitsstation in der Nähe des Substrathalters (12) angeordnet ist und der ein Targetmaterial des ausgewählten Materials aufweist, das sich zur Erzeugung eines ersten Plasmas eignet, um mindestens ein Material auf das Substrat (5) aufzusputtern, sowie einen sekundären Plasmamechanismus (16) zur Erzeugung eines sekundären Plasmas, der in der Arbeitsstation in der Nähe des Magnetron-Sputtermechanismus (15) und in der Nähe des Substrathalters (12) angeordnet ist, umfasst, wobei der Magnetron-Sputtermechanismus (15) und der sekundäre Plasmamechanismus (16) eine Sputterzone und eine Aktivierungszone bilden, **dadurch gekennzeichnet, dass** mindestens zwei Elektromagnete (1, 3) und/oder radial magnetisierte Ringmagnete sowie mindestens ein magnetischer Multipol (2), der aus mehreren Permanentmagneten gebildet wird, so angeordnet sind, dass sie Magnetfelder erzeugen, um das sekundäre Plasma einzuschließen.

2. Einrichtung nach Anspruch 1, **dadurch gekennzeichnet, dass** es sich bei dem Substrathalter (12) um eine Trommel handelt, und dass mindestens ein Elektromagnet (1) und/oder ein radial magnetisierter Ringmagnet innerhalb der Trommel (12) angeordnet sind/ist.

3. Einrichtung nach Anspruch 1, **dadurch gekennzeichnet, dass** sämtliche zur Erzeugung der Magnetfelder angeordnete Magnete (1, 2, 3) außerhalb der Vakuumkammer (11) angeordnet sind.

4. Einrichtung nach Anspruch 1 oder 2, **dadurch gekennzeichnet, dass** sämtliche zur Erzeugung der Magnetfelder angeordnete Magnete (1, 2, 3) innerhalb der Vakuumkammer angeordnet sind.

5. Einrichtung nach einem der vorangegangenen Ansprüche, **dadurch gekennzeichnet, dass** mindestens ein Elektromagnet zur Erzeugung eines magnetischen Wechselfeldes an eine Wechselspannungsquelle angeschlossen ist.

6. Einrichtung nach einem der vorangegangenen Ansprüche, **dadurch gekennzeichnet, dass** mindestens ein Elektromagnet zur Erzeugung eines konstanten Magnetfeldes an eine Gleichspannungsquelle angeschlossen ist.

7. Einrichtung nach einem der vorangegangenen Ansprüche, **dadurch gekennzeichnet, dass** mindestens ein Elektromagnet so betrieben wird, dass ein überlagertes konstantes und Wechselfeld erzeugt wird.

8. Einrichtung nach einem der vorangegangenen Ansprüche, **dadurch gekennzeichnet, dass** es sich bei dem sekundären Plasmamechanismus (16) um einen Mikrowellengenerator handelt.

9. Einrichtung nach Anspruch 8, **dadurch gekennzeichnet, dass** der Mikrowellengenerator (16) so eingerichtet ist, dass er eine gepulste Mikrowelle erzeugt.

10. Einrichtung nach den Ansprüchen 8 und 9, **dadurch gekennzeichnet, dass** die maximale Magnetflussdichte der durch die angeordneten Magneten (1, 2, 3) erzeugten Magnetfelder zumindest der erforderlichen Magnetflussdichte entspricht, die auf die zur Erzeugung von ECR (Electron Cyclotron Resonance) verwendete Mikrowellenfrequenz abgestimmt ist.

11. Einrichtung nach einem der vorangegangenen Ansprüche, **dadurch gekennzeichnet, dass** an den Substrathalter (12) ein Potential angelegt wird, das sich von dem Potential der Vakuumkammer (11) unterscheidet.

12. Einrichtung nach einem der vorangegangenen Ansprüche, **dadurch gekennzeichnet, dass** das sekundäre Plasma eine Reaktion bewirkt, um das ausgewählte Material in ein Oxid, Nitrid, Carbid, Hydrid, Sulfid, Oxynitrid oder Mischungen daraus umzuwandeln.

13. Einrichtung nach einem der vorangegangenen Ansprüche, **dadurch gekennzeichnet, dass** das sekundäre Plasma ein sauerstoffreiches Plasma ist, und dass die hervorgerufene Reaktion eine Oxidation ist.

14. Verfahren zur Beschichtung eines Substrats, wobei zuerst Material auf ein Substrat mittels eines Sputterprozesses aufgebracht wird und das aufgebrachte Material sodann in einem Plasma reagiert, das die erforderliche reaktive Spezies enthält, um eine Verbindung herzustellen, **dadurch gekennzeichnet, dass** die Plasmadichte und der Grad der Ionisierung des Plasmas mit Hilfe von Magnetfeldern erhöht werden, die durch die Einrichtung nach einem der vorangegangenen Ansprüche erzeugt werden.

15. Verfahren nach Anspruch 14, **dadurch gekennzeichnet, dass** die maximale Magnetflussdichte der durch die angeordneten Magneten (1, 2, 3) erzeugten Magnetfelder zumindest der erforderlichen Magnetflussdichte entspricht, die auf die zur Erzeugung von ECR (Electron Cyclotron Resonance) verwendete Mikrowellenfrequenz abgestimmt ist.

## Revendications

1. Dispositif (10) pour pulvériser au moins un matériau sélectionné sur un substrat (5) et entraîner une réaction de ce matériau, le dispositif comprenant une chambre à vide (11), dans laquelle un porte-substrat (12) est agencé, au moins un mécanisme de pulvérisation de magnétron (15), qui est agencé dans un poste de travail près du porte-substrat (12) et qui possède une cible du matériau sélectionné qui est approprié pour produire un premier plasma pour pulvériser au moins un matériau sur le substrat (5), ainsi qu'un mécanisme à plasma secondaire (16) pour produire un plasma secondaire, qui est agencé dans le poste de travail près du mécanisme de pulvérisation de magnétron (15) et près du porte-substrat (12), le mécanisme de pulvérisation de magnétron (15) et le mécanisme à plasma secondaire (16) formant une zone de pulvérisation et une zone d'activation, **caractérisé en ce qu'**au moins deux électroaimants (1, 3) et/ou aimants toriques magnétisés radialement ainsi qu'au moins un multipôle magnétique (2), qui est formé à partir d'une pluralité d'aimants permanents, sont agencés pour produire des champs magnétiques pour comprendre le plasma secondaire.

2. Dispositif selon la revendication 1, **caractérisé en ce que** le porte-substrat (12) est un tambour et **en ce qu'**au moins un électroaimant (1) et/ou un aimant torique magnétisé radialement est agencé à l'intérieur du tambour (12).

3. Dispositif selon la revendication 1, **caractérisé en ce que** tous les aimants (1, 2, 3) agencés pour produire les champs magnétiques sont agencés à l'extérieur de la chambre à vide (11).

4. Dispositif selon la revendication 1 ou 2, **caractérisé en ce que** tous les aimants (1, 2, 3) agencés pour produire les champs magnétiques sont agencés à l'intérieur de la chambre à vide.

5. Dispositif selon une quelconque des revendications précédentes, **caractérisé en ce qu'**au moins un électroaimant pour produire un champ alternatif magnétique est connecté à une source de tension alternative.

6. Dispositif selon une quelconque des revendications précédentes, **caractérisé en ce qu'**au moins un électroaimant pour produire un champ magnétique constant est connecté à une source de tension directe.

7. Dispositif selon une quelconque des revendications précédentes, **caractérisé en ce qu'**au moins un électroaimant est mis en fonctionnement de manière telle qu'un champ constant et alternatif superposé est produit.

8. Dispositif selon une quelconque des revendications précédentes, **caractérisé en ce que** le mécanisme à plasma secondaire (16) est un générateur de micro-onde.

9. Dispositif selon la revendication 8, **caractérisé en ce que** le générateur de micro-onde (16) est réglé pour produire une micro-onde pulsée.

10. Dispositif selon les revendications 8 et 9, **caractérisé en ce que** la densité de flux magnétique maximum des champs magnétiques produits par les aimants agencés (1, 2, 3) correspond au moins à la densité de flux magnétique nécessaire assortie à la fréquence de micro-onde utilisée pour produire une résonance cyclotronique électronique (ECR).

11. Dispositif selon une quelconque des revendications précédentes, **caractérisé en ce qu'**un potentiel est appliqué au niveau du porte-substrat (12), qui est différent du potentiel de la chambre à vide (11).

12. Dispositif selon une quelconque des revendications précédentes, **caractérisé en ce que** le plasma secondaire entraîne une réaction pour convertir le matériau sélectionné en un oxyde, un nitrure, un carbure, un hydrure, un sulfure, un oxynitrure ou des mélanges de ceux-ci.

13. Dispositif selon une quelconque des revendications précédentes, **caractérisé en ce que** le plasma secondaire est un plasma riche en oxygène et **en ce que** la réaction entraînée est une oxydation.

14. Procédé pour enduire un substrat, dans lequel premièrement un matériau est déposé sur un substrat au moyen d'un procédé de pulvérisation et le matériau déposé réagit alors dans un plasma, qui contient l'espèce réactive nécessaire, pour former un composé, **caractérisé en ce que** la densité de plasma et le degré d'ionisation du plasma sont augmentés à l'aide de champs magnétiques, qui sont produits par le dispositif selon une quelconque des revendications précédentes.

15. Procédé selon la revendication 14, **caractérisé en ce que** la densité de flux magnétique maximum des champs magnétiques produits par les aimants agencés (1, 2, 3) correspond au moins à la densité de flux magnétique nécessaire assortie à la fréquence de micro-onde utilisée, pour produire une résonance cyclotronique électronique (ECR).
